# EUROPÄISCHE PATENTSCHRIFT

(11) **EP 1 351 271 B1**
(45) Veröffentlichungstag und Bekanntmachung des Hinweises auf die Patenterteilung: **02.04.2008**
(21) Anmeldenummer: 03002448.3
(22) Anmeldetag: 05.02.2003
(51) Int. Cl.: H01J 37/20, H01J 37/26, G02B 21/32

(54) **Manipulator für ein optisches oder teilchenoptisches Gerät**
Manipulator for an optical or particle/optical device
Manipulateur pour un appareil optique ou à particules

(30) Priorität: 22.03.2002 DE 10212807
(43) Veröffentlichungstag der Anmeldung: 08.10.2003
(73) Patentinhaber: Carl Zeiss NTS GmbH, 73447 Oberkochen (DE)
(72) Erfinder: Müller, Helmut, 73527 Schwäbisch Gmünd (DE); Tobias, Daniel, 73447 Oberkochen (DE)
(74) Vertreter: Gnatzig, Klaus

(56) Entgegenhaltungen:
- US-A- 3 419 717
- US-A- 4 591 722

## Beschreibung

Die Erfindung betrifft einen Manipulator für ein optisches oder teilchenoptisches Gerät, insbesondere einen Blenden- oder Probenmanipulator für ein Elektronenmikroskop. Derartige Manipulatoren weisen in der Regel einen Übertragungskörper auf, der relativ zu einem am Gerätegehäuse aufzunehmenden Bauteil in zwei oder drei Raumrichtungen beweglich ist und an einem Ende das zu manipulierende Bauteil, z.B. die zu manipulierende Blende trägt. Da durch die einfallende Strahlung stets dem zu manipulierenden Bauteil Energie zugeführt wird und es demzufolge zu einer Erwärmung des zu manipulierenden Bauteils kommt, besteht der Übertragungskörper in der Regel aus einem Metall, um die Wärme in Richtung auf das Gehäuse abzuführen.

Entsprechende Manipulatoren für Blenden oder Mehrfachblenden sind beispielsweise von den Transmissions-Elektronenmikroskopen "LEO 912" oder "LEO 922" der Anmelderin bekannt. Aus der JP 86048248 (JP 55134933) ist es bekannt, eine Blende für ein Elektronenmikroskop mehrschichtig aus einem inneren Hartmetall und einer das Hartmetall umgebenden äußeren Schicht aus einem Metall mit hoher thermischer Leitfähigkeit her zu stellen. Ein Manipulator wie dargelegt im Oberbegriff Anspruchs 1 ist bekannt aus US 4 591 722.

Trotz der Verwendung von thermisch gut leitenden Übertragungskörpern treten dennoch durch die verbleibende Erwärmung und die damit einhergehende thermische Ausdehnung der Bauteile des Manipulators thermische Driften z.B. der Blenden auf, insbesondere wenn der auf die Blende einfallende Energiestrom variiert; dieses führt dann dazu, dass nach einer Änderung des Energiestromes die Position der eingeschalteten Blende nachjustiert werden muss.

Es ist daher das Ziel der vorliegenden Erfindung, einen Manipulator anzugeben, der keine oder nur stark reduzierte thermische Driften des zu manipulierenden Bauteils zeigt . Dieses Ziel wird mit einem Manipulator mit den Merkmalen des Anspruches 1 gelöst. Vorteilhafte Ausführungsformen der Erfindung ergeben sich aus den Merkmalen der abhängigen Ansprüche.

Beim erfindungsgemäßen Manipulator ist wie bei bekannten Manipulatoren das zu manipulierende Bauteil über einen relativ zu einem ortsfesten Bauteil beweglichen Übertragungskörper aufgenommen. Jedoch enthält der Übertragungskörper einen thermisch anisotropen Verbundwerkstoff, wobei die Richtung der größeren thermischen Leitfähigkeit in Richtung der Verbindungsachse zwischen dem zu manipulierenden Bauteil und dem ortsfesten Bauteil ausgerichtet ist.

Durch die hohe thermische Leitfähigkeit mindestens in Richtung der Verbindungsachse zwischen dem zu manipulierenden Bauteil und dem ortsfesten Bauteil kann die im zu manipulierenden Bauteil erzeugte Wärme sehr effizient auf das ortsfeste Bauteil abgeleitet werden.

In Richtung der Verbindungsachse sollte der Übertragungskörper gleichzeitig einen verschwindenden oder negativen thermischem Ausdehnungskoeffizienten aurweisen. Durch den verschwindenden oder sogar negativen thermischen Ausdehnungskoeffizienten in Richtung der Verbindungsachse zwischen dem zu manipulierenden Bauteil und dem ortsfesten Bauteil wird die verbleibende thermische Ausdehnung - und damit die verbleibende thermische Drift - sehr gering gehalten, bei negativem thermischem Ausdehnungskoeffizienten wird sogar durch den Übertragungskörper eine verbleibende thermische Ausdehnung anderer Komponenten teilweise kompensiert.

Als geeignetes Material für den Verbundwerkstoff kommt vorzugsweise ein faserverstärktes pechverbundenes (pitch-based) orientiertes Graphit in betracht. Die Fasern können dabei Kohlefasern sein. Derartige Materialien werden z.B. von der Firma BP Amoco Polymers Inc. unter den Bezeichnungen "ThermalGraph" mit den Typen "6000X", "7000X" und "8000X" angeboten.

Die thermische Leitfähigkeit in Richtung der Verbindungsachse zwischen dem zu manipulierenden Bauteil und dem am Gehäuse aufzunehmenden Bauteil sollte größer als die thermische Leitfähigkeit von Kupfer sein, also größer als 378 W/mK, vorzugsweise größer als 600 W/mK sein.

Der vorliegenden Erfindung liegt insbesondere die Erkenntnis zugrunde, dass für den Übertragungskörper durchaus ein thermisch anisotropes Material in Frage kommt, wenn nur eine hinreichende Wärmeleitfähigkeit in Richtung der Verbindungsachse zwischen dem zu manipulierenden Bauteil und dem am Gehäuse aufzunehmenden Bauteil gewährleistet ist, und dass die wesentlich geringere thermische Leitfähigkeit in der dazu senkrechten Richtung sich nicht störend auswirkt. Die geringe thermische Leitfähigkeit senkrecht zur Verbindungsachse zwischen dem zu manipulierenden Bauteil und dem ortsfesten Bauteil , vergleichbar der geringen thermischen Leitfähigkeit eines Wärmeisolators, mit gleichzeitig relativ großem thermischem Ausdehnungskoeffizienten senkrecht zur Verbindungsachse führt dann dazu, dass die thermische Ausdehnung in Richtung der Verbindungsachse negativ sein kann. Demzufolge sollte die Faserrichtung des Verbundwerkstoffes in Richtung der Verbindungsachse zwischen dem zu manipulierenden Bauteil und dem ortsfesten Bauteil ausgerichtet sein.

Zur effizienten Wärmeübertragung von dem zu manipulierenden Bauteil auf den Übertragungskörper sollte ein Ende des Übertragungskörpers mit einer Schrägfläche versehen sein, die zur Richtung der Verbindungsachse zwischen dem zu manipulierenden Bauteil und dem ortsfesten Bauteil geneigt ist. Das zu manipulierende Bauteil sollte an dieser Schrägfläche mit flächigem Kontakt aufgenommen sein. Durch die Schrägfläche wird eine weitgehende Optimierung der zur Wärmeübertragung ausgenutzten Fläche erreicht.

Zur Ableitung der Wärme vom Übertragungskörper auf das ortsfeste Bauteil - und damit auf das Gerätegehäuse oder in die Umwelt - sollte ein weiteres Bauteil vorgesehen sein, mit dem der Übertragungskörper mit dem der Schrägfläche gegenüber liegenden Ende in flächigem Kontakt steht.

Weiterhin kann eine Metallhülse vorgesehen sein, die den Übertragungskörper mindestens in Teilbereichen umgibt. Mithilfe einer solchen Metallhülse lassen sich die sonst aufgrund der teilweise schlechten mechanischen Belastbarkeit des Materials des Übertragungskörpers auftretenden mechanischen Probleme lösen.

Insbesondere für Manipulatoren in Teilchenstrahlgeräten, wie Elektronenmikroskopen, oder anderen Geräten mit ionisierender Strahlung, bei denen die Strahlführung im Vakuum erfolgt, sollte der Manipulator eine Vakuumdichtung aufweisen und der Übertragungskörper durch die Vakuumdichtung hindurch geführt sein. Die Ein- und Ableitung der Wärme von dem Übertragungskörper oder einem weiteren Bauteil, das mit dem Übertragungskörper in flächigem Kontakt steht, auf das Gerätegehäuse oder in die Umwelt kann dann durch die Luft außerhalb des Vakuumbereiches erfolgen.

Im Bereich der Vakuumdichtung kann ein Kipplager für den Übertragungskörper vorgesehnen sein, so dass der Übertragungskörper die für die Bewegung des zu manipulierenden Bauteils erforderlichen Freiheitsgrade aufweist.

Nachfolgend werden weitere Einzelheiten der Erfindung anhand des in den Figuren dargestellten Ausführungsbeispiels näher erläutert. Dabei zeigen:
- Figur 1:: einen Schnitt durch einen erfindungsgemäßen Manipulator am Beispiel eines Blendenhalters;
- Figur 2:: einen Schnitt durch den Manipulator in Figur 1 in einer zur Figur 1 senkrechten Schnittebene und
- Figur 3:: einen Ausschnitt eines Transmissionselektronenmikroskopes mit einem erfindungsgemäßen Manipulator als Blendenhalter.

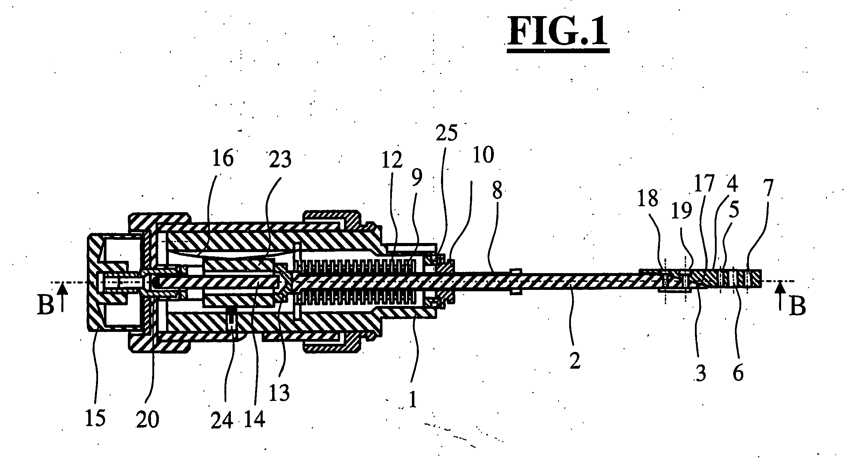

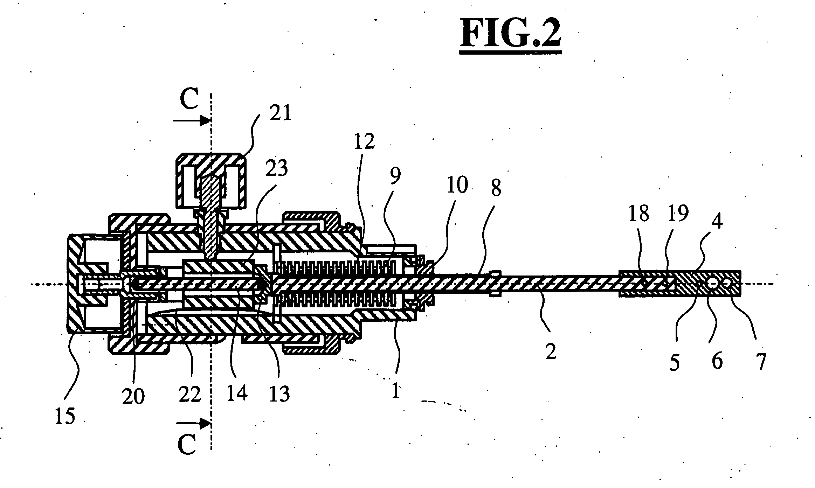

Der Manipulator in den Figuren 1 und 2 hat ein Fassungsteil (1) aus Metall, mit dem es an einer Wand eines Gerätegehäuses, z.B. dem Vakuumrohr eines Elektronenmikroskopes, aufnehmbar ist. Im Fassungsteil (1) ist ein stabförmiger Übertragungskörper (2) aus einem Kohlefaser Verbundwerkstoff bewegbar aufgenommen. An dem vom Fassungsteil (1) abgewandten Ende trägt der Übertragungskörper (2) das zu manipulierende Bauteil, im dargestellten Ausführungsbeispiel einen Blendenträger (4) mit drei darauf angeordneten Blenden (5, 6, 7) unterschiedlicher Durchmesser.

Das Material des Übertragungskörper (2) ist dabei ein kohlefaserverstärkter orientierter Graphit, wie er beispielsweise von der Firma BP Amoco Polymers Inc. unter der Bezeichnung "ThermalGraph 8000X" angeboten wird. Dieses Material hat stark anisotrope thermische Eigenschaften und ist in Faserrichtung sehr stark thermisch leitend mit einer thermischen Leitfähigkeit von 800 W/mK, in der zur Faserrichtung senkrechten Richtung hingegen eher schwach thermisch leitend mit einer thermischen Leitfähigkeit von 20 W/mK. Gleichzeitig hat das Material in Faserrichtung einen negativen thermischen Ausdehnungskoeffizienten von - 1,7 ppm/°C, so dass der Überträgungskörper bei einer Erwärmung zumindest in Faserrichtung schrumpft.

Aufgrund der anisotropen thermischen Eigenschaften des Übertragungskörpers wird dessen Material so orientiert, dass die Faserrichtung des Verbundwerkstoffes mit der Richtung der Verbindungsachse (B-B) zwischen dem zu manipulierenden Bauteil (4) und dem am Gehäuse aufzunehmenden Bauteil (1) zusammen fällt.

Um eine gute thermische Ankopplung zwischen dem zu manipulierenden Bauteil (4) und dem Übertragungskörper (2) zu erreichen, weist der Übertragungskörper (2) an dem Ende, an dem das zu manipulierende Bauteil aufgenommen ist, eine Schrägfläche (3) auf, d.h. das Ende des Übertragungskörpers (2) ist angeschrägt und schließt mit der Verbindungsachse (B-B) zwischen dem zu manipulierenden Bauteil (4) und dem am Gehäuse aufzunehmenden Bauteil (1) einen Neigungswinkel von weniger als 45 ° ein. Das zu manipulierende Bauteil (4) weist eine korrespondierende Schrägfläche (17) auf. Der Übertragungskörper (2) und das zu manipulierende Bauteil (4) sind über senkrecht zur Verbindungsachse (B-B) stehende Schrauben (18, 19) mit einander verschraubt. Anstelle einer Verschraubung senkrecht zur Verbindungsachse (B-B) ist auch eine Verschraubung senkrecht zu den Schrägflächen (3, 17) möglich. Durch die Schrägfläche (3) am Übertragungskörper (2) wird somit eine vergrößerte Fläche zur Verfügung gestellt, über die Wärme in Richtung der stärkeren thermischen Leitfähigkeit - also in Faserrichtung - in den Übertragungskörper eingekoppelt wird. Gleichzeitig wird über die Schraubverbindung eine gute thermische Kopplung und eine flächige Verbindung zwischen dem Übertragungskörper (2) und dem zu manipulierenden Bauteil (4) erreicht.

Der Übertragungskörper (2) ist an der vom zu manipulierenden Bauteil (4) abgewandten Seite in einer Metallhüllse (8) fest aufgenommen. Diese Metallhülse (8) dient einerseits dazu, die von der nachfolgend noch näher beschriebenen Manipulatormimik erzeugten Kräfte senkrecht zur Faserrichtung des Übertragungskörpers (2) auf zu nehmen, und andererseits um den Übertragungskörper auf der Seite, die dem zu manipulierenden Bauteil (4) gegenüber liegt, mit seiner Stirnfläche flächig mit einem weiteren Bauteil (23) zu verbinden. Dazu weist die Metallhülse (8) auf der Seite, die dem zu manipulierenden Bauteil (4) gegenüber liegt, einen Flansch mit einer Überwurfmutter (13) auf, durch die ein Bauteil (23) mit der Stirnfläche des Übertragungskörpers (2) in flächigem Kontakt gehalten wird.

Die in den Übertragungskörper eingekoppelte und in Faserrichtung zur Stirnfläche des Übertragungskörpers transportierte Wärme wird über die Stirnfläche in das weitere Bauteil (23) eingekoppelt und von dort über die Luft und die Blattfedern (16, 22) und über ein im Inneren des Metallrohres aufgenommenes knochenförmiges Bauteil (14) an das Fassungsteil (1) weiter geleitet. Damit die Ableitung der Wärme über die Luft erfolgen kann, ist es erforderlich, dass das weitere Bauteil (23) außerhalb des Vakuumbereiches liegt. Deshalb erfolgt die Vakuumdichtung noch im Bereich des Übertragungskörpers (2).

Die Metallhülse (8) ist über ein Kippgelenk (10) am Fassungsteil (1) bewegbar gelagert. Im Inneren des Fassungsteils (1) ist die Metallhülse (8) von einer Spiral-Druckfeder (9) umgeben, die selbst wieder von einem Metallbalg (12) umgeben ist. Die Spiral-Druckfeder (9) dient dabei zur Erzeugung einer Rückstellkraft in Richtung der Verbindungsachse (B-B) zwischen dem zu manipulierenden Bauteil (4) und dem am Gehäuse aufzunehmenden Bauteil (1). Die Feineinstellung des zu manipulierenden Bauteils (4) in Richtung der Verbindungsachse (B-B) erfolgt über einen Bedienknopf (15), der über ein Gewinde (20) eine Schraube fasst, welche durch einen eingedrehten Konus das knochenförmige Bauteil (14) aufnimmt. Bei einer Drehung des Bedienknopfes (15) wird bei einem Herausdrehen (Verlängern) des Gewindes (20) das knochenförmige Bauteil (14) und über das knochenförmige Bauteil (14) wiederum der Übertragungskörper (2) gegen die Kraft der Spiral-Druckfeder (9) in Richtung der Verbindungsachse (B-B) verschoben bzw. bei einem Hineindrehen (Verkürzen) des Gewindes drückt die Spiral-Druckfeder (9) die Metallhülse (8) in Richtung auf den Bedienknopf (15).

Für die Manipulation der Blenden (5, 6, 7) senkrecht zur Richtung der Verbindungsachse (B-B) sind zwei weitere Stellschrauben (21, 24) vorgesehen, die senkrecht zur Richtung der Verbindungsachse (B-B) am Fassungsteil (1) aufgenommen sind und jeweils über ein Gewinde auf das Bauteil (23) drücken, das das knochenförmige Bauteil (14) umgibt. Zur Erzeugung einer Rückstellkraft sind zwischen dem Fassungsteil (1) und dem Bauteil (23) zwei Blattfedern (16, 22) angeordnet, die jeweils bei einer Auslenkung des Bauteils (23) eine Rückstellkraft in zu einander senkrechten Richtungen erzeugen.

Um wahlweise eine der drei Blendenöffnungen (5, 6, 7) in den Strahlengang einzuschalten, ist in dem Fassungsteil (1) noch ein Stufentrieb mit einer Rastung integriert. Bei einer Schaltung um eine Stufe wird jeweils der Blendenträger um eine Strecke in Richtung der Verbindungsachse (B-B) bewegt, die dem Abstand jeweils zwischen den Mittelpunkten zweier Blendenöffnungen (5, 6, 7) entspricht.

Zur Vakuumdichtung ist die Spiraldruckfeder (9) von dem Metallbalg (12) umgeben, der mit dem Bauteil (23) und einem Dichtring (25) vakuumdicht verbunden, z.B. verlötet, ist. Im Inneren des Metallbalges (12) kann dadurch Vakuum sein, während außerhalb des Metallbalges (12) der Umgebungsdruck herrscht. Der Dichtring (25) ist von dem das Kipplager haltenden Teil an das Fassungsteil (1) geklemmt.

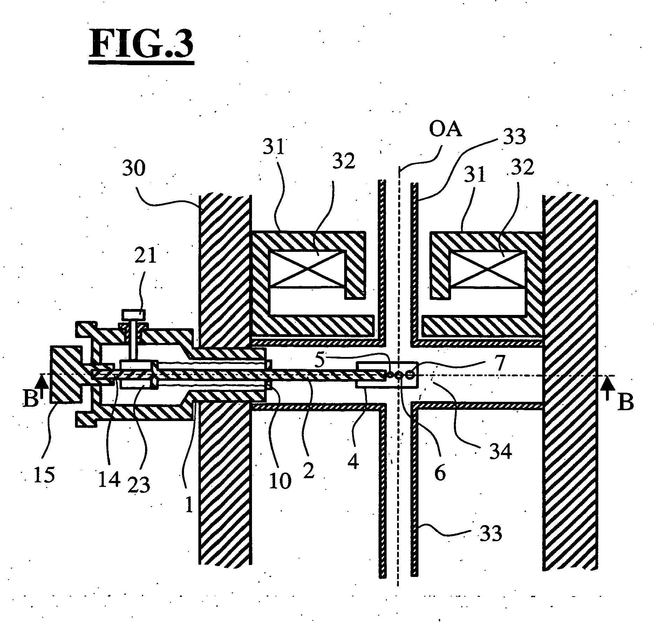

In der Figur 3 ist der zuvor beschrieben Manipulator in Verbindung mit einem ausschnittsweise dargestellten Elektronenmikroskop dargestellt. Das Elektronenmikroskop hat ein als Gehäuse dienendes Stahlrohr (30) in dem die elektronenoptischen Komponenten, wie Elektronenquelle, Kondensorlinsen, Objektivlinsen, Projektivlinsen, Ablenksysteme Stigmatoren etc. entlang einer optischen Achse (OA) aufgenommen sind. In dem in der Figur 3 dargestellten Ausschnitt ist von diesen elektronenoptischen Komponenten nur eine einzige, nämlich eine Magnetlinse mit ihrem Polschuh (31) und der Magnetspule (32) gezeigt.

Im inneren des Stahlrohres ist das Strahlführungsrohr (33) angeordnet, das das zur Führung der Elektronen erforderliche Vakuum gegenüber den Magnetspulen (32) abgrenzt. Dieses Strahlführungsrohr hat in dem Bereich, in dem eine Blende (4) anzuordnen ist, einen Vakuumdurchbruch, also einen verbreiterten Bereich (34), in dem das Vakuum bis an das Stahlrohr (30) angrenzt. In diesem Bereich (34) des Vakuumdurchbruches ist der Blendenmanipulator mit seinem Fassungsteil (1) in einer Bohrung durch das Stahlrohr (30) aufgenommen. Durch Schalten des oben genannten Stufentriebes kann wahlweise eine der Blendenöffnungen (5, 6, 7) im Blendenträger in den Strahlengang eingeschaltet werden und nachfolgend durch Drehen der Bedienknöpfe (15, 21) justiert werden.

Durch den oben beschriebenen Aufbau des Manipulators wird die an dem Blendenträger (5) durch den Elektronenstrahl erzeugte Wärme sehr effizient über den Übertragungskörper (2) aus dem Vakuumbereich heraus geführt und über das weitere Bauteil (14) und nachfolgend über die das weitere Bauteil (14) umgebende Luft an das Fassungsteil (1) und von dort auf das Stahlrohr (30) abgeleitet.

Durch den negativen Ausdehnungskoeffizienten des Übertragungskörpers (2) in Richtung der Verbindungsachse (B-B) oder senkrecht zur optischen Achse (OA) in Figur 3 wird gleichzeitig die unvermeidbare thermische Ausdehnung des Blendenträgers (4) in Richtung der Verbindungsachse (B-B) teilweise kompensiert.

Versuche haben ergeben, dass der für den Übertragungskörper verwendete Verbundwerkstoff auch im Hochvakuum keine nennenswerte Ausgasung zeigt und deshalb auch im Hochvakuum problemlos einsetzbar ist.

Anhand der Figuren wurde die Erfindung am Beispiel eines Blendenmanipulators erläutert, einer bevorzugten Anwendung des Manipulators. Er ist jedoch auch problemlos als Probenmanipulator oder auch für andere Manipulatoren einsetzbar, indem an dem Übertragungskörper (2) ein entsprechendes anderes zu manipulierendes Bauteil als ein Blendenträger aufgenommen wird.

Anhand des in den Figuren dargestellten Ausführungsbeispiels wurde die Erfindung am Beispiel eines manuellen Manipulators beschrieben. Vorteilhaft kann jedoch auch eine Ausbildung als motorischer Manipulator mit motorischen Antrieben für die Manipulationsbewegungen sein. Diese ermöglicht es, die Bewegungsmimik des Manipulators nahe an dem zu manipulierenden Bauteil anzuordnen, z.B. indem bei einem Elektronenmikroskop der gesamte Manipulator im Inneren der Säule aufgenommen ist. Dadurch lässt sich der Abstand zwischen dem zu manipulierenden Bauteil - dessen Position gleichzeitig auch thermisch stabil zu halten ist - und dem die thermische Stabilität gewährleistenden Punkt (in der manuellen Ausführungsform in den Figuren 1 und 2 die durch die Bedienknöpfe (15, 21) und die Schraube (24) angetriebenen Bauteile) reduzieren. Insgesamt ist durch diesen kürzeren Abstand eine höhere thermische Stabilität erreichbar.

## Patentansprüche

1. Manipulator für ein optisches oder teilchenoptisches Gerät, insbesondere Blenden- oder Probenmanipulator in einem Elektronenmikroskop, wobei das zu manipulierende Bauteil (4) über einen relativ zu einem ortsfesten Bauteil (1) beweglichen Übertragungskörper (2) aufgenommen ist **dadurch gekennzeichnet dass** der Übertragungskörper (2) einen thermisch anisotropen Verbundwerkstoff enthält und die Richtung der höheren thermischen Leitfähigkeit in Richtung der Verbindungsachse zwischen dem zu manipulierenden Bauteil (4) und dem ortsfesten Bauteil (1) ausgerichtet ist.

2. Manipulator nach Anspruch 1, wobei der Übertragungskörper (2) einen verschwindenden oder negativen thermischen Ausdehnungskoeffizienten in Richtung der Verbindungsachse (B-B) zwischen dem zu manipulierenden Bauteil (4) und dem ortsfesten Bauteil (1) aufweist.

3. Manipulator nach Anspruch 1 oder 2, wobei der Verbundwerkstoff ein faserverstärktes Graphit ist.

4. Manipulator nach Anspruch 3, wobei der Verbundwerkstoff Kohlefasern enthält.

5. Manipulator nach einem der Ansprüche 1-4, wobei die thermische Leitfähigkeit des Übertragungskörpers (2) in Richtung der Verbindungsachse (B-B) zwischen dem zu manipulierenden Bauteil (4) und dem ortsfesten Bauteil (1) größer als 378 W/mK, vorzugsweise größer 600 W/mK beträgt.

6. Manipulator nach einem der Ansprüche 1 - 5, wobei die thermische Leitfähigkeit des Übertragungskörpers (2) senkrecht zur Verbindungsachse (B-B) zwischen dem zu manipulierenden Bauteil (4) und dem ortsfesten Bauteil (1) der eines Wärmeisolators entspricht.

7. Manipulator nach einem der Ansprüche 1 - 6, wobei ein Ende des Übertragungskörpers (2) mit einer Schrägfläche (3) versehen ist, die zur Richtung der Verbindungsachse (B-B) zwischen dem zu manipulierenden Bauteil (4) und dem ortsfesten Bauteil (1) geneigt ist und das zu manipulierende Bauteil (4) an dieser Schrägfläche (3) mit flächigem Kontakt aufgenommen ist.

8. Manipulator nach einem der Ansprüche 1 - 7, wobei zur Ableitung der Wärme an das ortsfeste Bauteil (1) ein weiteres Bauteil (14) vorgesehen ist und der Übertragungskörper (2) mit dem der Schrägfläche (3) gegenüber liegenden Ende in flächigem Kontakt zu diesem weiteren Bauteil (14) steht.

9. Manipulator nach einem der Ansprüche 1 - 8, wobei eine den Übertragungskörper (2) umgebenden Metallhülse (8) vorgesehen ist.

10. Manipulator nach einem der Ansprüche 1 - 9, wobei der Manipulator eine Vakuumdichtung aufweist und der Übertragungskörper (2) durch die Vakuumdichtung hindurch geführt ist.

11. Manipulator nach Anspruch 10, wobei im Bereich der Vakuumdichtung ein Kipplager (10) für den Übertragungskörper (2) vorgesehen ist.

12. Elektronenmikroskop mit elektronenoptischen Komponenten und einem Manipulator nach einem der Ansprüche 1 bis 11.

## Claims

1. Manipulator for an optical or particle-optical apparatus, in particular diaphragm or sample manipulator in an electron microscope, wherein the component (4) to be manipulated is received via a transfer body (2) which moves in relation to a positionally fixed component (1), **characterized in that** the transfer body (2) comprises a thermally anisotropic composite material and the direction of the higher thermal conductivity is aligned in the direction of the connecting axis between the component (4) to be manipulated and the positionally fixed component (1).

2. Manipulator according to Claim 1, in which the transfer body (2) has a negligible or negative coefficient of thermal expansion in the direction of the connecting axis (B-B) between the component (4) to be manipulated and the positionally fixed component (1).

3. Manipulator according to Claim 1 or 2, in which the composite material is a fibre-reinforced graphite.

4. Manipulator according to Claim 3, in which the composite material contains carbon fibres.

5. Manipulator according to one of Claims 1 - 4, in which the thermal conductivity of the transfer body (2) in the direction of the connecting axis (B-B) between the component (4) to be manipulated and the positionally fixed component (1) is greater than 378 W/mK, preferably greater than 600 W/mK.

6. Manipulator according to one of Claims 1 - 5, in which the thermal conductivity of the transfer body (2) perpendicular with respect to the connecting axis (B-B) between the component (4) to be manipulated and the positionally fixed component (1) corresponds to that of a thermal insulator.

7. Manipulator according to one of Claims 1 - 6, in which one end of the transfer body (2) has an oblique surface (3) which is inclined with respect to the direction of the connecting axis (B-B) between the component (4) to be manipulated and the positionally fixed component (1) and the component (4) to be manipulated is received on this oblique surface (3) with areal contact.

8. Manipulator according to one of Claims 1 - 7, in which a further component (14) is provided for transferring the heat to the positionally fixed component (1) and that end of the transfer body (2) which lies opposite the oblique surface (3) is in areal contact with this further component (14).

9. Manipulator according to one of Claims 1 - 8, in which a metal sleeve (8) surrounding the transfer body (2) is provided.

10. Manipulator according to one of Claims 1 - 9, in which the manipulator has a vacuum seal and the transfer body (2) is guided through the vacuum seal.

11. Manipulator according to Claim 10, in which a tilting bearing (10) for the transfer body (2) is provided in the region of the vacuum seal.

12. Electron microscope with electron-optical components and a manipulator according to one of Claims 1 to 11.

## Revendications

1. Manipulateur pour un appareil optique ou optique à particules, notamment manipulateur de diaphragme ou d'échantillon dans un microscope électronique, le composant à manipuler (4) étant accueilli par un corps de transmission (2) mobile par rapport à un composant fixe (1), **caractérisé en ce que** le corps de transmission (2) contient un matériau composite thermiquement anisotrope et la direction de la conductivité thermique la plus élevée est orientée dans la direction de l'axe de liaison entre le composant à manipuler (4) et le composant fixe (1).

2. Manipulateur selon la revendication 1, le corps de transmission (2) présentant un coefficient de dilatation thermique infiniment petit ou négatif en direction de l'axe de liaison (B-B) entre le composant à manipuler (4) et le composant fixe (1).

3. Manipulateur selon la revendication 1 ou 2, le matériau composite étant un graphite renforcé par des fibres.

4. Manipulateur selon la revendication 3, le matériau composite contenant des fibres de carbone.

5. Manipulateur selon l'une des revendications 1 à 4, la conductivité thermique du corps de transmission (2) en direction de l'axe de liaison (B-B) entre le composant à manipuler (4) et le composant fixe (1) étant supérieure à 378 W/mK, de préférence supérieure à 600 W/mK.

6. Manipulateur selon l'une des revendications 1 à 5, la conductivité thermique du corps de transmission (2) perpendiculairement à l'axe de liaison (B-B) entre le composant à manipuler (4) et le composant fixe (1) correspondant à celle d'un isolateur thermique.

7. Manipulateur selon l'une des revendications 1 à 6, une extrémité du corps de transmission (2) étant munie d'une surface biseautée (3) qui est inclinée en direction de l'axe de liaison (B-B) entre le composant à manipuler (4) et le composant fixe (1) et le composant à manipuler (4) est accueilli sur cette surface biseautée (3) avec un contact à plat.

8. Manipulateur selon l'une des revendications 1 à 7, un composant (14) supplémentaire étant prévu pour dissiper la chaleur au niveau du composant du composant fixe (1) et le corps de transmission (2) est en contact à plat avec ce composant supplémentaire (14) par son extrémité à l'opposé de la surface biseautée (3).

9. Manipulateur selon l'une des revendications 1 à 8, une douille métallique (8) entourant le corps de transmission (2) étant prévue.

10. Manipulateur selon l'une des revendications 1 à 9, le manipulateur présentant une garniture d'étanchéité sous vide et le corps de transmission (2) passant à travers la garniture d'étanchéité sous vide.

11. Manipulateur selon la revendication 10, un palier de basculement (10) pour le corps de transmission (2) étant prévu dans la zone de la garniture d'étanchéité sous vide.

12. Microscope électronique équipé de composant électro-optiques et d'un manipulateur selon l'une des revendications 1 à 11.
